# FASCICULE DE BREVET EUROPEEN

(11) **EP 0 561 261 B1**
(45) Date de publication et mention de la délivrance du brevet: **02.07.1997**
(21) Numéro de dépôt: 93103801.2
(22) Date de dépôt: 10.03.1993
(51) Int. Cl.: H03L 7/26, H01S 1/06

(54) **Etalon de fréquence atomique**
Atomfrequenzstandard
Atomic frequency standard

(30) Priorité: 16.03.1992 FR 9203210
(43) Date de publication de la demande: 22.09.1993
(73) Titulaire: Tekelec Neuchâtel Time S.A., 2008 Neuchâtel (CH)
(72) Inventeur: Schweda, Hartmut S., CH-2525 Le Landeron (CH); Busca, Giovanni, CH-2000 Neuchâtel (CH); Rochat, Pascal, CH-2074 Marin (CH)
(74) Mandataire: Patry, Didier Marcel Pierre

(56) Documents cités:
- GB-A- 966 126
- US-A- 3 798 565
- US-A- 4 123 727
- Proceedings of the 41st Annual Frequency Control Symposium - 1987, pages 75-81, New York, U.S.A.; PETERS et al.: 'Hydrogen maser for radio astronomy'
- RADIO ENGINEERING AND ELECTRONIC PHYSICS vol. 26, no. 11, Novembre 1981, Washington, US, p. 151; BOCHKOV et al. : 'Small-resonator hydrogen maser'
- Proceedings of the 41st Annual Frequency Control Symposium - 1987, pages 25-35, New York, U.S.A., HASHIMOTO et al.: 'Ultra-sensitive frequency discrimination in a diode laser pumped Rb87 atomic clock.'
- PATENT ABSTRACTS OF JAPAN vol. 9, no. 35 (E-296)(1758) 14 Février 1985 & JP-A-59 178 783

## Description

La présente invention est relative aux étalons de fréquence et, plus particulièrement, à des étalons de ce type comprenant une cavité de résonance, des moyens de stockage se trouvant dans la cavité de résonance et destinés à stocker des particules atomiques ou moléculaires, et des moyens de chauffage pour apporter de la chaleur à la cavité de résonance.

Les étalons de fréquence sont des dispositifs caractérisés par des fréquences de fonctionnement extrêmement précis, et dont le système de résonance fondamentale consiste en un atome ou une molécule ayant une transition entre deux niveaux d'énergie bien définis. Le principe général de fonctionnement des étalons de fréquence est décrit dans le livre intitulé "The Quantum Physics of Atomic Frequency Standards " par J. Vanier et C. Andion, publié par Adam Hilger, Bristol et Philadelphie, 1989.

Certains modes de réalisation d'étalons de fréquence utilisant une cellule à gaz et un maser sont décrits dans le brevet suisse CH 640 370 et le brevet américain US 4 316 153.

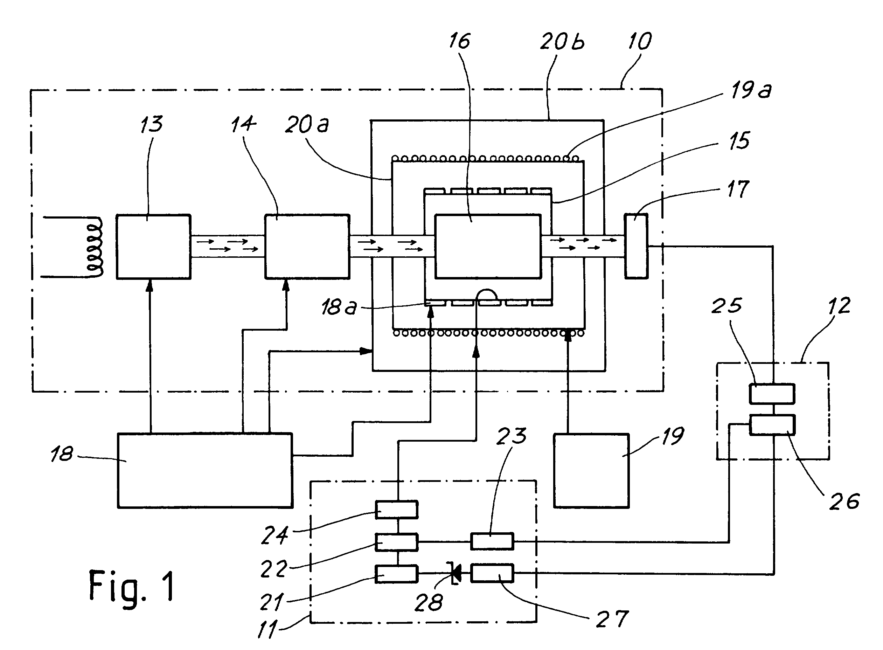

Afin d'illustrer le fonctionnement d'un étalon de fréquence connu, on va maintenant décrire un tel étalon utilisant une cellule à gaz en faisant référence à la figure 1 des dessins annexés.

L' étalon de fréquence représenté schématiquement à la figure 1 comprend essentiellement un résonateur atomique 10, un oscillateur à cristal et ,associé à celui-ci, un circuit 11 multiplicateur de fréquence ou synthétiseur, ainsi qu'un circuit de réaction 12. Le résonateur atomique 10 comprend principalement une lampe 13, une cellule de filtrage 14, une cavité à micro-ondes 15, une cellule d'absorption 16 et une cellule photoélectrique 17. Une source d'alimentation 18 fournit l'énergie nécessaire pour exciter l'oscillateur et son circuit associé 11, et la lampe 13 et pour commander la température des divers composants du résonateur atomique 10. Une bobine de chauffage classique 18a est alimentée et commandée également par la source d'alimentation 18.

Une autre source d'alimentation 19 fournit de l'énergie pour engendrer le champ magnétique de la cavité à micro-ondes 15 par l'intermédiaire d'une bobine 19a. De plus, la cavité à micro-ondes 15 est entourée par un écran magnétique 20b pour éviter que des champs magnétiques externes ne puissent perturber le fonctionnement du résonateur atomique 10.

Dans l'étalon de fréquence atomique représenté à la figure 1, une inversion de population est produite par pompage optique entre les niveaux hyperfins de l'état fondamental des atomes qui sont en général des métaux alcalins tels que le potassium, le sodium ou le rubidium. On va maintenant décrire un dispositif de pompage classique utilisé dans un tel étalon de fréquence au rubidium.

La cellule d'absorption 16 contient l'isotope de rubidium 87 dont le spectre comprend deux composantes hyperfines A et B, la cellule contenant également un gaz tampon approprié tel que l'azote. La cellule d'absorption 16 est exposée à la lumière de la lampe 13 au rubidium 87 à travers la cellule de filtrage 14 qui contient de la vapeur au rubidium 85 dont le spectre d'absorption comprend les composantes hyperfines a et b. Les composantes A et a sont pratiquement en coïncidence, mais les composantes B et b sont complètement séparées. C'est pourquoi la composante A du spectre d'émission de la lampe 13 est pratiquement entièrement éliminée par la cellule de filtrage 14 de sorte que la lumière qui atteint la cellule d'absorption 16 est principalement constituée par de la lumière ayant la fréquence de la bande B. Seuls les atomes du rubidium 87 de la cellule d'absorption 16 se trouvant au niveau hyperfin inférieur (F = 1) absorbent la lumière et sont transférés vers des états supérieurs.

Après excitation des atomes de rubidium dans la cellule d'absorption 16, ceux-ci subissent une relaxation soit vers le niveau supérieur hyperfin (F = 2) soit vers le niveau inférieur hyperfin de l'état fondamental, en raison des collisions de ces atomes avec les molécules d'azote du gaz tampon. Comme ces atomes sont excités dès leur illumination par la lumière, le niveau inférieur (F = 1) subit une réduction de population au profit du niveau supérieur (F = 2). En raison de l'asymétrie de la lumière de pompage, on obtient ainsi une inversion de population de ces deux niveaux de sorte que la cellule d'absorption 16 devient pratiquement transparente au rayonnement résiduel de la lampe 13.

La cellule d'absorption 16 est disposée dans la cavité à micro-ondes 15 qui est excitée par le circuit 11 à une fréquence voisine de 6835 MHz. Celle-ci correspond à l'énergie de séparation des niveaux hyperfins F = 1, m_{f} = 0 et F = 2, m_{f} = 0. Il en résulte une transition hyperfine accompagnée d'une émission de rayonnement électromagnétique entre ces deux niveaux.

Dès que les atomes participant à l'émission stimulée parviennent au niveau inférieur hyperfin (F = 1), ils sont pompés optiquement pour être portés vers leurs états excités.

Au cours de ce processus, l'écran magnétique 20b assure un faible niveau du champ externe ambiant, un faible champ magnétique axial et uniforme étant produit par la bobine magnétique 19a alimentée par la source d'alimentation 19. Le champ magnétique ainsi produit dans la cellule d'absorption 16 déplace les niveaux d'énergie des niveaux hyperfins en vertu de l'effet Zeeman bien connu et ajuste ainsi la fréquence exacte du rayonnement électromagnétique émis grâce à l'émission stimulée que l'on vient de décrire.

La quantité de lumière absorbée par la cellule d'absorption 16 sera d'autant plus grande et la quantité de lumière atteignant la cellule photoélectrique 17 sera d'autant plus faible que le nombre d'émissions stimulées sera plus grand. Le courant engendré par la cellule photoélectrique 17 est ainsi à une valeur minimale, lorsque la fréquence du signal d'excitation de la cavité à micro-ondes est à sa valeur de transition.

L'oscillateur à quartz 21 du circuit produit un signal à 5 MHz qui est modulé dans un modulateur de phase 22 à une fréquence relativement faible (environ 100 Hz à 1 kHz) engendrée par un générateur à basse fréquence 23. Le signal modulé est appliqué à un multiplicateur/synthétiseur 24 destiné à produire un signal présentant la fréquence d'émission stimulée de 6835 MHz. Ce signal est utilisé pour exciter la cavité à micro-ondes 15.

Le signal fourni par la cellule photoélectrique 17 est reçu par un amplificateur 25 du circuit de réaction 12, ce signal étant ensuite appliqué à un comparateur de phase 26 qui reçoit également un signal de référence du générateur 23 du circuit 11, afin de réaliser une détection synchrone permettant de déterminer si la fréquence porteuse du signal appliqué à la cavité à micro-ondes 15 est correctement centrée sur la fréquence de transition hyperfine (6835 MHz). Tout déphasage donne lieu à un signal d'erreur apparaissant à la sortie du comparateur de phase 26. Ce signal est appliqué à un intégrateur 27 utilisé pour commander une diode Zener 28 connectée à l'oscillateur à quartz 21 pour en modifier la fréquence de manière à maintenir le centrage de la fréquence multipliée de cet oscillateur à quartz 21 sur la fréquence de la transition hyperfine du rubidium 87.

La stabilité et la précision de la fréquence de fonctionnement de l'étalon de fréquence atomique de la figure 1, dépendent de l'interaction entre les atomes ou les molécules se trouvant dans la cellule d'absorption 16 et du champ électromagnétique présent dans la cavité à micro-ondes 15, pendant que ces atomes ou molécules subissent l'émission stimulée décrite ci-dessus. Le champ électromagnétique dans la cavité à micro-ondes 15 a pratiquement la même fréquence et la même longueur d'onde que le rayonnement de transition hyperfine atomique ou moléculaire, les dimensions de cette cavité à micro-ondes 15 étant liées à la longueur d'onde du rayonnement.

La stabilité et la précision de la fréquence de fonctionnement du résonateur atomique 10 dépendent également d'une bonne régulation en température de la lampe 13, de la cellule d'absorption 16 et de la cellule de filtrage 14. Ceci est lié au fait que la fréquence de transition hyperfine déterminée par la fréquence multipliée de l'oscillateur à quartz 21 et détectée par le signal lumineux frappant la cellule photoélectrique 17, est influencée par le processus de pompage optique qui se produit simultanément. La fréquence de transition hyperfine est légèrement décalée en fonction du spectre et de l'intensité de la lumière absorbée, ces paramètres étant à leur tour fonction des températures de la lampe 13, du filtre 14 et de la cellule d'absorption 16. De plus, les décalages des fréquences de transition hyperfine provoqués par des collisions avec le gaz tampon sont fonction de la pression et de la température du rubidium 87 et du gaz tampon présents dans la cellule d'absorption 16.

Dans certains résonateurs atomiques de l'art antérieur qui ne nécessitent pas de chauffage et/ou de régulation de température des particules atomiques ou moléculaires de la cellule d'absorption, on a déjà disposé des électrodes autour de la cellule d'absorption à l'intérieur de la cavité à micro-ondes afin de réduire les dimensions de cette cavité et d'intensifier et d'orienter le champ électromagnétique dans la région de la cellule d'absorption se trouvant dans cette cavité. La concentration du champ électromagnétique qui en résulte dans la région de la cellule d'absorption rend optimaux le facteur de remplissage et le facteur de qualité du résonateur à cavité à micro-ondes. Le facteur de remplissage est le rapport de l'énergie magnétique totale dans l'espace occupé par les particules atomiques ou moléculaires se trouvant dans la cellule d'absorption, par l'énergie magnétique totale dans le résonateur; la réponse du résonateur atomique sera d'autant meilleure que le facteur de remplissage est plus élevé. Le facteur de qualité est le rapport de la fréquence du mode de résonance considéré de la cavité, par la largeur du pic de résonance, ce rapport étant déterminé par le rapport de l'énergie emmagasinée dans la cavité par l'énergie perdue dans celle-ci.

Toutefois, les électrodes de ces résonateurs de la technique antérieure sont liées à la cellule d'absorption et maintenues en position les unes par rapport aux autres, par l'intermédiaire de moyens de fixation tels qu'une résine appropriée. Les propriétés diélectriques des moyens de fixation utilisés réduisent l'intensité et l'uniformité du champ électromagnétique présent dans la cellule d'absorption. De plus, ces électrodes sont thermiquement et électriquement isolées des parois de la cavité et sont conçues en fonction d'équations basées sur cette séparation électrique et thermique.

De telles électrodes constituent également une masse thermique à l'intérieur de la cavité à micro-ondes rendant ainsi plus difficile une détermination précise de la température de cette cavité et de la cellule d'absorption. Les électrodes bloquent le transfert thermique entre d'une part les parois de la cavité à micro-ondes et d'autre part l'intérieur de celle-ci ainsi que la cellule d'absorption située en son voisinage, ce qui diminue le temps de réponse thermique du résonateur atomique. Il en résulte un emmagasinage puis un rayonnement thermique, alors que précisément il est souhaitable que l'échauffement de la cavité à micro-ondes soit réduit.

Dans les résonateurs atomiques de la technique antérieure, il est nécessaire de fournir de l'énergie non seulement pour chauffer l'intérieur de la cellule d'absorption où la température est importante, mais également pour chauffer d'autres zones de la cavité à micro-ondes dans lesquelles une régulation précise de la température n'est pas nécessaire.

De plus, le fait que des zones de la cavité à micro-ondes autres que la cellule d'absorption, sont chauffées signifie que le temps d'échauffement initial des étalons de fréquence atomiques de la technique antérieure est plus grand que souhaité.

La présente invention a pour but de fournir un étalon de fréquence atomique qui remédie tout au moins en partie aux inconvénients des étalons de fréquence de la technique antérieure.

L'invention a ainsi pour objet un étalon de fréquence atomique comprenant une cavité de résonance disposée dans une enveloppe, des moyens de stockage disposés dans ladite cavité à résonance pour stocker des particules atomiques ou moléculaires, des moyens de production d'un champ pour soumettre les moyens de stockage à un champ magnétique oscillant uniforme, des moyens de sélection d'état pour amener lesdites particules dans un état d'énergie prédéterminé, des moyens d'interrogation pour stimuler des transitions d'un état d'énergie prédéterminé à un autre état d'énergie prédéterminé à une fréquence prédéterminée, et des moyens de chauffage destinés à appliquer de la chaleur à ladite enveloppe, ce étalon de fréquence étant caractérisé en ce qu'au moins une électrode est disposée autour desdits moyens de stockage pour améliorer le champ magnétique oscillant desdites transitions stimulées dans la région des moyens de stockage, ladite électrode étant reliée à ladite enveloppe par au moins un organe thermiquement conducteur de manière à appliquer de la chaleur auxdits moyens de stockage.

D'autres caractéristiques et avantages de l'invention apparaîtront au cours de la description qui va suivre, donnée uniquement à titre d'exemple et faite en se référant aux dessins annexés sur lesquels:
la figure 1, déjà décrite, représente schématiquement un étalon de fréquence atomique conformément à la technique antérieure;
la figure 2 représente une vue latérale en coupe d'un résonateur atomique destiné à être utilisé dans un étalon de fréquence atomique de la présente invention; et
la figure 3 est une vue en plan et en coupe du résonateur atomique de la figure 2, prise selon la ligne III-III de la figure 2.

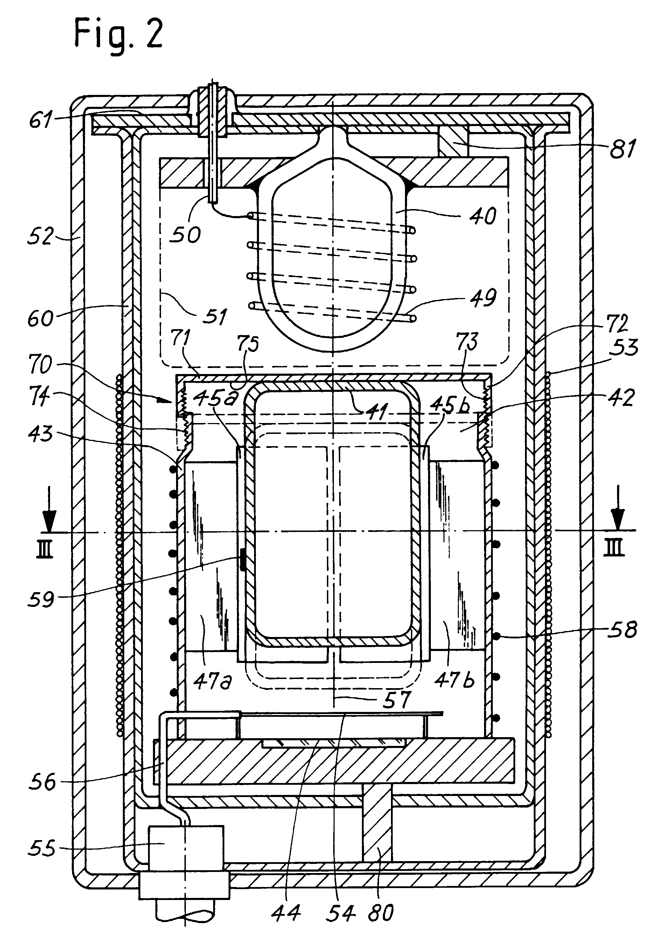

L'agencement selon l'invention de l'étalon de fréquence atomique représenté à la figure 2 comprend essentiellement une lampe 40, une cellule d'absorption 41, une cavité à micro-ondes 42 présentant une paroi 43, une cellule photoélectrique 44, des électrodes 45a à 45d et des organes de connexion 47a à 47d.

La lampe 40 contient essentiellement du rubidium 87, ou un mélange de rubidium 87 et de rubidium 85 ainsi qu'un gaz de déclenchement approprié tel que de l'argon. Cette lampe est placée à l'intérieur d'une bobine d'excitation 49 connectée à un câble 50 qui est la charge inductive d'un oscillateur de fréquence radio dont la fréquence est située entre 100 et 150 MHz. Une grille 51 est agencée autour de cet ensemble pour éviter que le signal ne rayonne vers la cellule d'absorption 41 et la cellule photoélectrique 44.

Un circuit de chauffage classique (non représenté) comprenant une résistance de chauffage et un détecteur de température est utilisé pour maintenir la lampe à une température constante de 140°C, par exemple.

La cellule d'absorption 41 est placée en regard de la lampe 40. Dans le mode de réalisation représenté, la cellule d'absorption contient du rubidium 85, du rubidium 87 ainsi qu'un gaz tampon approprié qui peut être de l'azote ou un mélange d'azote et de méthane. Elle a un diamètre de 14 mm et une longueur de 25 mm, par exemple c'est-à-dire un volume interne d'environ 3 cm³, par exemple.

Les atomes de rubidium 85 situés dans la partie de la cellule d'absorption 41 près de la lampe 40 absorbent la composante spectrale A de la lampe 40 ce dont il résulte un filtrage, tandis que les atomes du rubidium 87 situés dans la partie de la cellule d'absorption 41 éloignée de la lampe 40 absorbent la composante spectrale B de celle-ci, ce dont il résulte le pompage optique nécessaire pour déterminer l'état des atomes de rubidium 87. Selon une variante, un filtre isotopique peut être combiné à une source alcaline pour constituer une lampe qui rayonne de la lumière pré-filtrée vers la cellule d'absorption 41. Une autre variante encore consiste à utiliser une diode laser comme source lumineuse ce qui permet d'éliminer toute nécessité de filtrage.

La cavité à micro-ondes 42 est protégée des champs magnétiques externes par un écran magnétique 52. Elle est en outre soumise à un champ magnétique uniforme créé par un enroulement 53 et à un champ à fréquence micro-onde créé par une boucle à micro-ondes 54 excitée par un oscillateur externe par l'intermédiaire d'un connecteur 55 et d'un câble coaxial 56. La boucle 54 peut comprendre une diode à coupure brusque (diode SRD) qui multiplie la fréquence du signal fourni par l'oscillateur ce qui permet ainsi d'utiliser un oscillateur à fréquence relativement basse.

La cavité à micro-ondes 42 comporte un dispositif de commande de chauffage et de température destiné à maintenir la température de la cellule d'absorption 41 à sa valeur de fonctionnement normal qui peut être de 85°C dans le cas d'une cellule à gaz au rubidium 87. Du courant électrique peut être injecté dans un filament de chauffage bifilaire 58 enroulé autour de la paroi 43 de la cavité à micro-ondes 42 pour permettre d'y appliquer de la chaleur. Un détecteur de température 59 permet d'appliquer un signal de réaction au dispositif de commande de chauffage et de température afin de réguler la température de la cavité 42.

Celle-ci est excitée à une fréquence de résonance de 6835 MHz correspondant à la transition hyperfine du niveau F = 2, m_{f} = 0 au niveau F = 1, m_{f} = 0 des atomes de rubidium 87 dans la cellule d'absorption 41.

L'absorption de la composante B du spectre par les atomes de rubidium 87 dans la cellule d'absorption 42 est détectée par la cellule photoélectrique 44. Ce signal d'absorption est employé de façon classique pour asservir la fréquence du signal d'interrogation émis par la boucle 54 à la fréquence de la transition hyperfine entre les niveaux F = 2, m_{f} = 0 et F = 1, m_{f} = 0 du rubinium 87.

Les électrodes 45a à 45d entourent la cellule d'absorption 41 en étant centrées par rapport à l'axe longitudinal 57 de celle-ci pour confiner le champ magnétique oscillant dans la cavité 42 selon une orientation souhaitable et uniforme par rapport aux atomes du rubidium 87 qui sont orientés magnétiquement dans la cellule d'absorption 41. Ces électrodes augmentent également l'intensité du champ dans la cellule d'absorption 41 pour qu'il se produise un couplage optimal entre le champ et les atomes de rubidium 87 stockés dans la cellule 41. Il est à noter que les électrodes 45a à 45d telles que représentées ne sont que des exemples d'électrodes pouvant être utilisées et que l'on peut choisir d'autres orientations des électrodes autour de la cellule d'absorption que celles qui sont représentées. On peut utiliser un nombre quelconque d'électrodes autour de la cellule 41 et les dimensions, la forme ainsi que l'espacement mutuel des électrodes peuvent être différents.

Les organes de connexion 47a à 47d relient les électrodes 45a à 45d à la paroi 43 de la cavité à micro-ondes 42 et les maintiennent dans une position fixe les unes par rapport aux autres ce qui évite l'utilisation d'une résine ou d'un autre moyen de fixation susceptible de perturber l'uniformité et l'intensité du champ magnétique oscillant dans la région de la cellule d'absorption 42.

Les organes de connexion 47a à 47d sont réalisés en un matériau conducteur de la chaleur et ont de préférence une surface de contact contiguë aux électrodes dont l'aire est à peu près égale à celle de la surface de l'électrode respective afin de permettre un transfert thermique efficace de la chaleur fourni par l'enroulement de chauffage 58 entre la paroi 43 de la cavité à micro-ondes 42 vers ces électrodes 45a à 45d.

De préférence, les organes de connexion 47a à 47d remplissent à peu près l'espace entier délimité entre la surface externe des électrodes et la surface interne de la paroi 43 ce qui permet d'améliorer encore davantage le transfert thermique. Ainsi, la cellule d'absorption 41 peut être chauffée directement par les électrodes 45a à 45d, ce qui réduit le temps d'échauffement du résonateur atomique et l'erreur en fréquence qui en résulte et permet une meilleure homogénéité et une commande plus précise de la température du rubidium et du gaz tampon dans la cellule d'absorption 41. De plus, l'énergie nécessaire pour chauffer celle-ci peut être réduite car c'est elle seulement qui doit être maintenue à la température souhaitée plutôt que la cavité à micro-ondes dans son ensemble.

En présence d'un champ magnétique oscillant approprié dans la cavité à micro-ondes 42, les électrodes constituent une sorte de circuit électrique périphérique permettant la circulation circulaire d'un courant dans ces électrodes. Elles sont ainsi représentatives d'une certaine inductance. Les électrodes permettent également la circulation d'un courant autour de l'axe longitudinal 57 de la cellule 41, et définissent une certaine capacité en raison des épaisseurs de diélectriques correspondant aux intervalles entre les extrémités adjacentes des électrodes. Par conséquent, le positionnement et les dimensions de ces électrodes ont une influence sur la fréquence de résonance dominante de la cavité à micro-ondes 42.

En raison de cette capacité, un certain champ électrique est présent dans ces intervalles. La valeur des capacités, et par suite la valeur de la fréquence de résonance de la cavité à micro-ondes 42, est donc influencée par la constante diélectrique du matériau à travers lequel passe le champ électrique. La paroi de la cellule d'absorption 41 a de préférence une constante diélectrique différente de la constante diélectrique du milieu à travers lequel passe le champ électrique lorsque la cellule d'absorption 41 est absente. On comprendra donc que le mouvement relatif de la cellule 41 par rapport aux électrodes 45a-45d fera varier la proportion de champ électrique traversant la cellule 41, modifiant ainsi la capacité associée aux électrodes 45a-45d et décalant donc la fréquence de résonance de la cavité à micro-ondes 42.

L'étalon de fréquence atomique représenté à la figure 2, comprend de plus des moyens 70 destinés au positionnement des moyens de stockage 41 relativement aux électrodes 45a-45d. Les moyens de positionnement 70 comprennent un élément 71 en forme de coiffe comportant une jupe annulaire 72, et dont la surface intérieure comprend un filetage 73. La surface extérieure de l'enceinte 43 comporte également un filetage 74 destiné à coopérer avec le filetage 73 de la coiffe 71. La cellule d'absorption 41 est fixée à la surface intérieure 75 de la coiffe 71. De cette façon, le vissage ou le dévissage de la coiffe 71 par rapport à l'enceinte 42 produit respectivement l'engagement et le désengagement de la cellule d'absorption 41 d'entre les électrodes 45a-45d, modifiant ainsi la proportion du champ électrique qui traverse la cellule d'absoption 41. Les variations dans l'épaisseur des parois de la cellule d'absorption 41, dans les dimensions des électrodes 45a-45d et dans les dimensions d'autres composants qui sont situés à l'intérieur de l'étalon de fréquence et qui peuvent donc influencer la fréquence de résonance de la cavité à micro-ondes 42, peuvent ainsi être compensés en ajustant la position de la cellule d'absoption 41.

Le cellule d'absorption 41 peut être fixée à la coiffe 71 par des moyens convenables quelconques. Si toutefois la cellule 41 n'est pas portée par la coiffe 71, par exemple dans le cas où l'étalon de fréquence est disposé dans une position inverse à celle représentée à la figure 2, la cellule 41 n'a pas besoin d'être fixée à la coiffe 71. De plus, d'autres dispositions que celles représentées à la figure 2 peuvent être utilisées, pour permettre un mouvement relatif de la cellule 41 par rapport aux électrodes 45a-45d à l'intérieur de l'enceinte 43. Par exemple, la cellule d'absorption 41 peut être fixée à un membre en forme de coiffe qui coopère avec la paroi interne des enceintes 60 et 61. Ces dispositions et d'autres équivalentes mécaniques seront comprises par l'homme du métier et sont donc incluses dans la présente invention.

Un mode de réalisation de la présente invention a été produit qui comprend quatre électrodes, chacune ayant une épaisseur de 0,8 mm, et une longueur mesurée selon l'axe longitudinal de la bobine 58, de 12 mm. L'intervalle entre chacune des électrodes était de 0,6 mm. La cellule d'absorption utilisée avait une épaisseur de paroi comprise entre 0,2 et 0,3 mm et comportait une paroi réalisée dans un matériau ayant une constante diélectrique de 4,5. Selon cette disposition exemplaire, le jeu de compensation de l'étalon de fréquence, ou en d'autres termes la différence entre la fréquence de résonance de la cavité à micro-ondes 42 lorsque la cellule d'absorption 41 est introduite entièrement entre les électrodes 45a-45d par rapport à la fréquence de résonance lorsque la cellule 41 est complètement retirée, s'est avérée être de 400 MHz.

Dans une autre réalisation de l'invention, les organes de connexion 47a à 47d en coopération avec les électrodes 45a à 45d peuvent être utilisés pour assurer le support mécanique de la cellule d'absorption 41 à l'intérieur de la cavité à micro-ondes 42. La cellule peut ainsi être serrée, et par conséquent maintenue par rapport à la paroi 43 de la cavité au moyen des électrodes 45a à 45d ou, selon une variante, on peut même prévoir une fixation par collage par exemple au moyen d'un adhésif de la cellule 41 à ces électrodes 45a à 45d. D'ailleurs, à cet effet, il n'est pas nécessaire d'utiliser toutes les électrodes. De cette manière, la cellule d'absorption peut être placée dans la cavité à micro-ondes 42 de manière à optimaliser le champ magnétique oscillant dans la région de la cellule.

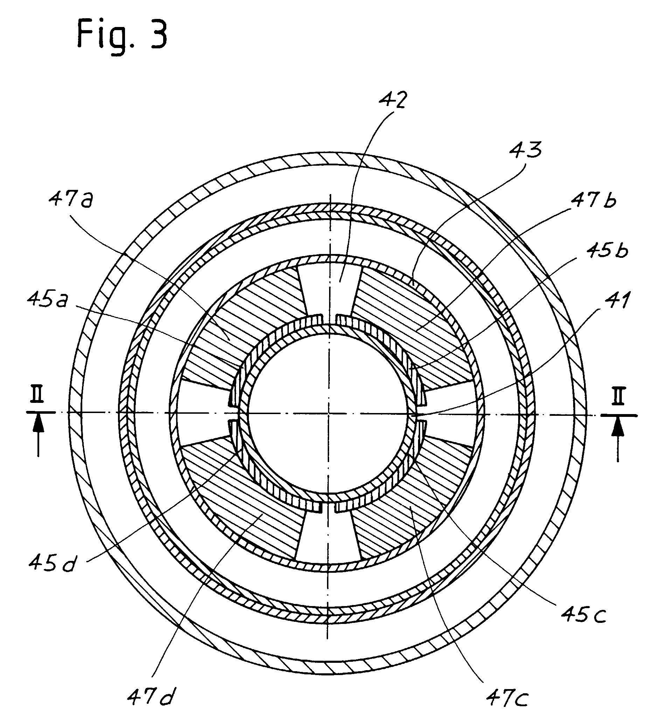

Dans l'agencement représenté aux figures 2 et 3, le flux magnétique oscillant créé par les structures résonnantes formées par les électrodes respectives 45a à 45d et les organes 47a à 47d s'est révélé être optimal au centre de la cavité à micro-ondes 42 si bien que la cellule d'absorption 41 peut être placée à cet endroit sans qu'il soit nécessaire d'utiliser d'autres éléments de support qui pourraient provoquer des pertes diélectriques et des perturbations du champ magnétique supplémentaires.

Afin d'augmenter la rigidité mécanique et de rendre plus facile la fabrication de l'étalon de fréquence atomique selon l'invention, il est possible, selon une caractéristique particulièrement avantageuse de celle-ci, de former une seule pièce comprenant soit la paroi 43 et les organes de support 47a à 47d, soit cette paroi et ces organes, ainsi ainsi que les électrodes 45a à 45d. Le récipient formé par l'enceinte 60 et le couvercle 61 est avantageusement mis sous vide procurant ainsi plusieurs avantages par rapport à des résonateurs de fréquence atomiques connus. Ces avantages sont les suivants:
premièrement, le flux thermique entre la lampe 40 et la cellule 41 est éliminé ce qui permet d'obtenir une meilleure commande de la température;
deuxièmement, la lampe 40 et la cellule 41 peuvent être placées plus près l'une de l'autre sans problème de sorte que l'on peut obtenir une réduction du volume de l'étalon de fréquence;
troisièmement, la plage à l'intérieur de laquelle le résonateur peut être utilisé est plus étendue, tandis que l'on peut améliorer la stabilité en fréquence du résonateur; et
quatrièmement, la consommation en énergie de l' étalon de fréquence est réduite.

De façon avantageuse, plusieurs éléments de l'étalon de fréquence atomique situés à l'intérieur de l'enveloppe 60, tels que la source lumineuse 40 et le résonateur 43 peuvent être connectés à celui-ci comme représenté sur la figure 2, par des entretoises 80 et 81 de faible conductibilité thermique. De cette façon, l'étalon de fréquence logé dans l'enceinte 60 peut être séparé thermiquement de celle-ci et ainsi ne pas être soumis aux influences des variations de température et de dilatation thermique résultant des variations ambiantes de température et de pression.

Au lieu de mettre l'enceinte 60 sous vide, celle-ci peut être également remplie d'un gaz de faible conductibilité thermique telle que le xénon ou un autre gaz moléculaire lourd approprié. Ce gaz peut être à la pression atmosphérique. Le fait de remplir l'enceinte de xénon permet d'obtenir les mêmes avantages que ceux que l'on obtient si l'enceinte était mise sous vide. Cependant, dans ce cas, on peut également se dispenser d'utiliser des matériaux présentant des propriétés de faible dégazage.

Enfin, il est à noter que plusieurs modifications peuvent être apportées à l'étalon de fréquence atomique selon l'invention sans sortir du cadre de celle-ci. En particulier, l'invention concerne aussi bien des étalons de fréquence atomiques passifs tels que les étalons à cellule au rubidium gazeux, que tous les étalons de fréquence atomiques dans lesquels on utilise des électrodes pour améliorer le champ magnétique oscillant.

## Revendications

1. Etalon de fréquence atomique comprenant une cavité de résonance (42) à l'intérieur d'une enveloppe (43), des moyens de stockage (41) se trouvant dans ladite cavité de résonance (42) et destinés à stocker des particules atomiques ou moléculaires, des moyens pour engendrer un champ (53) destinés à soumettre lesdits moyens de stockage (41) à un champ magnétique uniforme oscillant, des moyens de sélection d'état (40) pour amener lesdites particules dans un état d'énergie prédéterminé, des moyens (54) pour stimuler des transitions dudit état d'énergie prédéterminé vers un autre état d'énergie prédéterminé à une fréquence prédéterminée, et des moyens de chauffage (58) destinés à apporter de la chaleur à ladite enveloppe (43),
cet étalon de fréquence étant caractérisé en ce qu'au moins une électrode (45a à 45d) est disposée autour desdits moyens de stockage (41) afin d'améliorer ledit champ magnétique oscillant desdites transitions stimulées dans la région desdits moyens de stockage (41), ladite électrode (45a à 45d) étant connectée à ladite enveloppe (43) par au moins un organe thermiquement conducteur (47a à 47d) pour permettre l'application de la chaleur auxdits moyens de stockage.

2. Etalon de fréquence atomique selon la revendication 1, caractérisé en ce que lesdits organes (47a à 47d) sont d'une seule pièce avec ladite enveloppe (43).

3. Etalon de fréquence atomique selon la revendication 1 ou 2, caractérisé en ce qu'au moins l'un desdits organes (47a à 47d) est d'une seule pièce avec l'électrode respective qui lui est associée.

4. Etalon de fréquence atomique selon l'une quelconque des revendications précédentes, caractérisé en ce qu'il est du type passif et lesdits moyens de stockage (41) comprennent une cellule à gaz contenant un métal alcalin sous forme gazeuse.

5. Etalon de fréquence atomique selon l'une quelconque des revendications précédentes caractérisé en ce que lesdits moyens de stockage (41) contiennent du rubidium et un gaz tampon.

6. Etalon de fréquence atomique selon l'une quelconque des revendications précédentes, caractérisé en ce que lesdits moyens de sélection d'état (40) et lesdits moyens de stockage (41) sont disposés dans une enceinte (60,61) mise sous vide.

7. Etalon de fréquence atomique selon l'une quelconque des revendications précédentes, caractérisé en ce que lesdits moyens de sélection d'état (40) et lesdits moyens de stockage (41) sont disposés dans une enceinte (60,61) remplie d'un gaz ayant une faible conductibilité thermique.

8. Etalon de fréquence atomique selon la revendication 6 ou 7, caractérisé en ce que lesdits moyens de sélection (13) et ladite enveloppe (43) sont reliés a ladite enceinte (60,61) par l'intermédiaire d'entretoises (80,81) ayant une faible conductibilité thermique.

9. Etalon de fréquence atomique selon l'une quelconque des revendications précédentes, caractérisé en ce que lesdits moyens de sélection d'état (13) comprennent une source de lumière (40) ayant une composante spectrale prédéterminée qui produit par pompage optique une inversion de population dans ladite source de lumière (40).

10. Etalon de fréquence atomique selon la revendication 9, caractérisé en ce que ladite source de lumière comprend une lampe à métal alcalin (40).

11. Etalon de fréquence atomique selon la revendication 9, caractérisé en ce que ladite source de lumière (40) comprend une source alcaline et un filtre isotopique.

12. Etalon de fréquence atomique selon la revendication 9, caractérisé en ce que ladite source de lumière (40) comprend une diode laser.

13. Etalon de fréquence atomique selon l'une quelconque des revendications précédentes, caractérisé en ce que ladite électrode (45a à 45d) est supportée dans ladite cavité à résonance (42) grâce auxdits organes (47a à 47d).

14. Etalon de fréquence atomique selon l'une quelconque des revendications précédentes, caractérisé en ce que lesdits moyens de stockage (41) sont supportés à l'intérieur de ladite cavité de résonance (42) par l'intermédiaire d'au moins l'une desdites électrodes.

15. Etalon de fréquence selon l'une quelconque des revendications précédentes, caractérisé en ce que lesdits moyens de stockage (41) sont supportés au centre de ladite cavité de résonance (42).

16. Etalon de fréquence atomique selon l'une ou l'autre des revendications précédentes, caractérisé en ce que chacune desdites électrodes (45a-45d) comporte une pluralité d'extrémités, des extrémités adjacentes parmi ladite pluralité d'extrémités transmettant un champ électrique de l'une à l'autre, au moins une partie dudit champ électrique traversant lesdits moyens de stockage (41), ledit étalon de fréquence comprenant encore des moyens de positionnement (70) pour positionner lesdits moyens de stockage (41) relativement auxdites au moins une électrode (45a-45d) pour faire varier la proportion dudit champ électrique passant à travers lesdits moyens de stockage (41).

17. Etalon de fréquence atomique selon la revendication 16, caractérisé en ce que lesdits moyens de positionnement (70) sont prévus pour coopérer de façon désengageable dans une pluralité de positions avec ladite enveloppe (43).

18. Etalon de fréquence atomique selon la revendication 16 ou 17, caractérisé en ce que lesdits moyens de positionnement (70) et ladite enveloppe (43) peuvent coopérer l'un avec l'autre au moyen de filetages complémentaires, ledit positionnement desdits moyens de stockage (41) étant réalisés en vissant ou en dévissant lesdits moyens de positionnement (70) et ladite enveloppe (43).

19. Etalon de fréquence atomique selon l'une ou l'autre des revendications 16 à 18, caractérisé en ce que lesdits moyens de positionnement (70) comprennent une coiffe comportant une surface intérieure et une surface extérieure, ladite coiffe pouvant être fixée à ladite enveloppe (43), lesdits moyens de stockage (41) pouvant coopérer avec ladite surface intérieure.

## Patentansprüche

1. Atomares Frequenznormal, umfassend einen Resonanzhohlraum (42) innerhalb einer Hülle (43), innerhalb des Resonanzhohlraums (42) befindliche und zur Lagerung von atomaren oder molekularen Partikeln bestimmte Lagerungsmittel (41), zum Unterwerfen der Lagerungsmittel (41) unter ein gleichmäßiges oszillierendes Magnetfeld bestimmte Mittel zur Schaffung eines Feldes (53), Mittel zur Zustandsauswahl (40), um die Partikel in einen vorbestimmten Energiezustand zu versetzen, Mittel (54) zum Stimulieren von Übergängen des vorbestimmten Energiezustands zu einem anderen vorbestimmten Energiezustand bei einer vorbestimmten Frequenz, und Heizmittel (58), um der Hülle (43) Wärme zuzuführen,
wobei dieses Frequenznormal dadurch gekennzeichnet ist, daß wenigstens eine Elektrode (45a bis 45d) um die Lagerungsmittel (41) herum zur Verbesserung des oszillierenden Magnetfeldes der in dem Bereich der Lagerungsmittel (41) stimulierten Übergänge angeordnet ist, wobei die Elektrode (45a bis 45d) mit der Hülle (43) durch wenigstens ein Wärmeleitorgan (47a bis 47d) verbunden ist, um das Beaufschlagen der Lagerungsmittel mit der Wärme zu erlauben.

2. Atomares Frequenznormal nach Anspruch 1,
dadurch gekennzeichnet, daß die Organe (47a bis 47d) mit der Hülle (43) einstückig sind.

3. Atomares Frequenznormal nach Anspruch 1 oder 2,
dadurch gekennzeichnet, daß wenigstens eines der Organe (47a bis 47d) mit der jeweils mit ihm zugeordneten Elektrode einstückig ist.

4. Atomares Frequenznormal nach einem der vorhergehenden Ansprüche,
dadurch gekennzeichnet, daß es vom passiven Typ ist, und daß die Lagerungsmittel (41) eine Gaszelle umfassen, die ein im gasförmigen Zustand befindliches Alkalimetall enthält.

5. Atomares Frequenznormal nach einem der vorhergehenden Ansprüche,
dadurch gekennzeichnet, daß die Lagerungsmittel (41) Rubidium und ein Puffergas enthalten.

6. Atomares Frequenznormal nach einem der vorhergehenden Ansprüche,
dadurch gekennzeichnet, daß die Mittel zur Zustandsauswahl (40) und die Lagerungsmittel (41) in einem luftleeren Behälter (60, 61) angeordnet sind.

7. Atomares Frequenznormal nach einem der vorhergehenden Ansprüche,
dadurch gekennzeichnet, daß die Mittel zur Zustandsauswahl (40) und die Lagerungsmittel (41) in einem mit einem Gas von geringer Wärmeleitfähigkeit gefüllten Behälter (60, 61) angeordnet sind.

8. Atomares Frequenznormal nach Anspruch 6 oder 7, dadurch gekennzeichnet, daß die Mittel zur Auswahl (13) und die Hülle (43) über Distanzstücke (80, 81) mit geringer thermischer Leitfähigkeit mit dem Behälter (60, 61) verbunden sind.

9. Atomares Frequenznormal nach einem der vorhergehenden Ansprüche, dadurch gekennzeichnet, daß die Mittel zur Zustandsauswahl (13) eine Lichtquelle (40) mit einer vorbestimmten spektralen Komponente umfassen, die durch optisches Pumpen eine Populationsumkehr in der Lichtquelle (40) erzeugt.

10. Atomares Frequenznormal nach Anspruch 9, dadurch gekennzeichnet, daß die Lichtquelle eine Alkalimetallampe (40) umfaßt.

11. Atomares Frequenznormal nach Anspruch 9, dadurch gekennzeichnet, daß die Lichtquelle (40) eine Alkaliquelle und einen Isotopenfilter umfaßt.

12. Atomares Frequenznormal nach Anspruch 9, dadurch gekennzeichnet, daß die Lichtquelle (40) eine Laserdiode umfaßt.

13. Atomares Frequenznormal nach einem der vorhergehenden Ansprüche, dadurch gekennzeichnet, daß die Elektrode (45a bis 45d) in dem Resonanzhohlraum (42) mittels der Organe (47a bis 47d) abgestützt ist.

14. Atomares Frequenznormal nach einem der vorhergehenden Ansprüche, dadurch gekennzeichnet, daß die Lagerungsmittel (41) in dem Resonanzhohlraum (42) durch wenigstens eine der Elektroden abgestützt sind.

15. Atomares Frequenznormal nach einem der vorhergehenden Ansprüche, dadurch gekennzeichnet, daß die Lagerungsmittel (41) im Zentrum des Resonanzhohlraums (42) abgestützt sind.

16. Atomares Frequenznormal nach einem der vorhergehenden Ansprüche, dadurch gekennzeichnet, daß jede der Elektroden (45a bis 45d) eine Mehrzahl von Enden aufweist, wobei benachbarte Enden der Mehrzahl von Enden ein elektrisches Feld von den einen zur anderen übertragen, wobei wenigstens ein Teil des elektrischen Feldes die Lagerungsmittel (41) durchsetzt, wobei das Frequenznormal ferner Positioniermittel (70) zum Positionieren der Lagerungsmittel (41) im Verhältnis zu der wenigstens einen Elektrode (45a-45d) umfaßt, um den Anteil des die Lagerungsmittel (41) durchsetzenden elektrischen Feldes zu variieren.

17. Atomares Frequenznormal nach Anspruch 16, dadurch gekennzeichnet, daß die Positioniermittel (70) ausgebildet sind, um lösbar in einer Mehrzahl von Positionen mit der Hülle (43) zusammenzuwirken.

18. Atomares Frequenznormal nach Anspruch 16 oder 17, dadurch gekennzeichnet, daß die Positioniermittel (70) und die Hülle (43) mittels komplementärer Gewinde miteinander zusammenwirken können, wobei die Positionierung der Lagerungsmittel (41) durch Festschrauben oder Losschrauben der Positioniermittel (70) von der Hülle (43) erfolgt.

19. Atomares Frequenznormal nach einem der Ansprüche 16 bis 18, dadurch gekennzeichnet, daß die Positioniermittel (70) eine Abdeckung umfassen, die eine innere Oberfläche und eine äußere Oberfläche aufweist, wobei die Abdeckung an der Hülle (43) befestigbar ist, wobei die Lagerungsmittel (41) mit der inneren Oberfläche zusammenwirken können.

## Claims

1. Atomic frequency standard comprising a resonance cavity (42) within an enclosure (43), storage means (41) being in said resonance cavity (42) for the storage of atomic or molecular elements, field generation means (53) to subject said storage means (41) to a uniform oscillating magnetic field, state selection means (40) for placing said elements in a preselected energy state, means (54) for stimulating transitions from said preselected energy state to another preselected energy state at a predetermined frequency, and heating means (58) for supplying heat to said enclosure (43),
such frequency standard being characterized in that at least one electrode (45a to 45d) is disposed about said storage means (41) so as to thereby enhance said oscillating magnetic field of said stimulated transitions in the region of said storage means (41), said at least one electrode (45a to 45d) being connected to said enclosure (43) by one or more thermally conductive members (47a to 47d) so as to thereby supply said heat to said storage means (41).

2. Atomic frequency standard according to claim 1, characterized in that said members (47a to 47d) are integral with said enclosure (43).

3. Atomic frequency standard according to claim 1 or 2, characterized in that at least one of said members (47a to 47d) is integral with said at least one electrode (45a to 45d).

4. Atomic frequency standard according to any one of the preceding claims, characterized in that it is of a passive frequency device type and said storage means (41) comprises a gas cell containing an alkali metal in gaseous form.

5. Atomic frequency standard according to any one of the preceding claims, characterized in that said storage means (41) contains rubidium and a buffer gas.

6. Atomic frequency standard according to any one of the preceding claims, characterized in that said state selection means (40) and said storage means (41) are placed in a container (60,61) under vacuum.

7. Atomic frequency standard according to any one of the preceding claims, characterized in that said state selection means (40) and said storage means (41) are placed in a container (60,61) filled with a gas of low thermal conductivity.

8. Atomic frequency standard according to claim 6 or 7, characterized in that said state selection means (13) and said enclosure (43) are connected to said container (60,61) by low thermal conductivity spacers (80,81).

9. Atomic frequency standard according to any one of the preceding claims, characterized in that said state selection means (13) comprises a light source (40) having a predetermined spectral component which produces a population inversion in said light source (40) by optical pumping.

10. Atomic frequency standard according to claim 9, characterized in that said light source (40) comprises an alkali metal lamp.

11. Atomic frequency standard according to claim 9, characterized in that said light source (40) comprises an alkali source and an isotopic filter.

12. Atomic frequency standard according to claim 9, characterized in that said light source (40) comprises a diode laser.

13. Atomic frequency standard according to any one of the preceding claims, characterized in that said electrode (45a to 45d) is supported within said resonance cavity (42) by said members (47a to 47d).

14. Atomic frequency standard according to any one of the preceding claims, characterized in that said storage means (41) is supported within said resonance cavity (42) by at least one of said electrodes.

15. Atomic frequency standard according to any of the preceding claims, characterized in that said storage means (41) is supported centrally within said resonance cavity (42).

16. Atomic frequency standard according to any of the preceding claims, characterized in that each said electrode (45a-45d) has a plurality of extremities, adjacent ones of said extremities passing an electric field therebetween, at least some of said electric field passing through said storage means (41), said frequency standard further comprising means (70) for positioning said storage means (41) with respect to said at least one electrode (45a-45d) so as to vary the proportion of said electric field passing through said storage means (41).

17. Atomic frequency standard according to claim 16, characterized in that said positioning means (70) is releasably engagable in a plurality of positions with said enclosure (43).

18. Atomic frequency standard according to claim 16 or 17, characterized in that said positioning means (70) and said enclosure (43) are mutually engagable by means of cooperating screw-threads, wherein said positioning of said storage means (41) is performed by the screwing or unscrewing of said positioning means (70) and said enclosure (43).

19. Atomic frequency standard according to any of claims 16 to 18, characterized in that said positioning means (70) comprises a cap having an interior surface and an exterior surface, said cap being securable to said enclosure (43), said storage means (41) being engagable with said interior surface.
